# EUROPEAN PATENT APPLICATION

(11) **EP 4 790 746 A1**
(43) Date of publication of application: **12.08.2026**
(21) Application number: 25157001.6
(22) Date of filing: 11.02.2025
(51) Int. Cl.: H01L 21/67, B65G 47/91, F16C 32/04, H02K 7/04, H02K 7/09, H02K 37/00, F16C 39/00

(54) **BONDING TOOL**

(71) Applicant: ASML Netherlands B.V., 5500 AH Veldhoven (NL)
(72) Inventor: SEIJGER, Olav, Johannes, 5500 AH Veldhoven (NL)
(74) Representative: ASML Netherlands B.V.

(57) **Abstract**

A bonding tool comprises: a frame; a stage coupled to the frame, wherein the stage comprises a movable member configured to move relative to the frame such that an actuation force applied to the movable member causes a reaction force; and a balance mechanism configured to at least partly counteract the reaction force caused by the actuation force applied to the movable member.

## Description

### TECHNICAL FIELD

The present disclosure relates generally to a bonding tool, and a method for counteracting a reaction force within a bonding tool.

### BACKGROUND

In manufacturing processes of integrated circuits (ICs), multiple finished or unfinished ICs (e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple die - where these specific portions which may be aligned in three- dimensional space to ensure functional connectivity. Alignment of these die, which may have multiple fabrication layers, different critical dimensions, different nodes, packaging, etc., with each other may require different techniques than use for lithography during fabrication. As the physical sizes of IC components continue to shrink, and their structures continue to become more complex, accuracy and throughput in integration become more important. For applications such as heterogeneous integration, it may be desirable to obtain both accurate and fast placement of die with respect to one another.

In the context of semiconductor manufacture, improvements in die placement and alignment (e.g., improvements in heterogeneous integration) lead to improvements in IC manufacturing and integration abilities.

### SUMMARY

According to an embodiment, there is provided a bonding tool comprising: a frame; a stage coupled to the frame, wherein the stage comprises a movable member configured to move relative to the frame such that an actuation force applied to the movable member causes a reaction force; and a balance mechanism configured to at least partly counteract the reaction force caused by the actuation force applied to the movable member.

According to an embodiment, there is provided a method for counteracting a reaction force within a bonding tool, the method comprising: applying an actuation force to a movable member of a stage of the bonding tool so as to move the movable member relative to a frame of the bonding tool, wherein the stage is coupled to the frame; and at least partly counteracting the reaction force caused by the actuation force applied to the movable member with a balance mechanism.

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts, and in which:
Figures 1A-1D are schematic diagrams illustrating an exemplary die bonding method, according to an embodiment.
Figure 2 is a schematic diagram illustrating a method of placement of dies by a moveable stage with recesses, according to an embodiment.
Figure 3 is a schematic diagram of a stage for die placement.
Figure 4 is a schematic view of a guide for the stage of Figure 3.
Figure 5 is a schematic view of an alternative guide for the stage of Figure 3.
Figure 6 is a perspective view of an anti-drift mechanism for the stage of Figure 4.
Figure 7 is a schematic diagram of a stage with two balance mechanisms.
Figure 8 is a perspective view of an anti-drift mechanism and a balance mechanism for the stage of Figure 4.
Figure 9 is a schematic view of an alternative balance mechanism.
Figure 10 is a schematic view of an alternative balance mechanism.
Figure 11 is a schematic view of an optional feature of the balance mechanism of Figure 9 or Figure 10.
Figure 12 is a schematic view of an alternative balance mechanism.
Figure 13 is a schematic view of an anti-drift mechanism for the stage of Figure 12.
Figure 14 is a schematic view of an alternative anti-drift mechanism for the stage of Figure 12.
Figure 15 is a schematic view of an alternative balance mechanism.
Figure 16 is a schematic view of a housing for flexible elements.
Figure 17 is a schematic view of an alternative housing for flexible elements.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure. Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "wafer" or "die" in this text should be considered as interchangeable with the more general terms "substrate" and "target portion", respectively. The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions. A patterning device (for example, a lithography device) can comprise, or can form, one or more patterns, which may correspond to one or more die. The patterns can be generated utilizing CAD (computer-aided design) programs, based on a pattern or design layout, this process often being referred to as EDA (electronic design automation). As used throughout this application "or", unless indicated otherwise, takes a non-exclusive meaning, e.g., encompassing both "and" and "or".

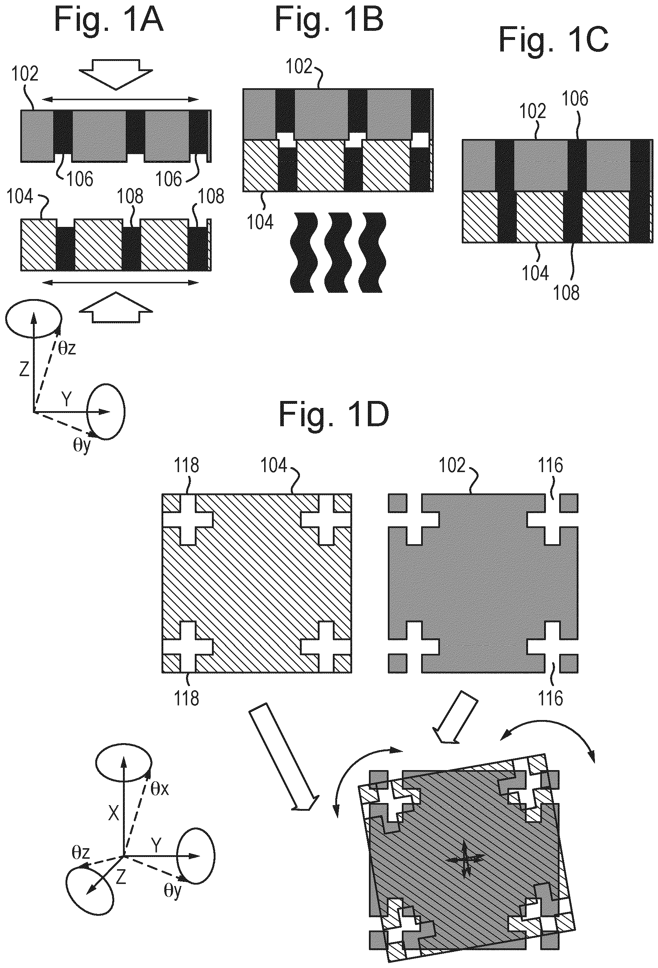

Reference is now made to Figures 1A-1D, which are schematic diagrams illustrating an exemplary die bonding method consistent with embodiments of the present disclosure. The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target locations.

As shown in Figures 1A-1D, the exemplary die bonding method may involve a donor die 102 and a target die 104. Herein, the term "donor" and the term "target" are used for ease of description. It should be understood that the term "donor" and the term "donor" are provided for reference and are relative and that elements described as corresponding to a "donor" can instead correspond to a "target" and vice versa. The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

As shown in Figure 1 A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. The alignment may be complicated by the multiple layers of the donor die 102 or the multiple layers of the target die 104, which may be optically opaque. Figures 1A-1C depict a cross-sectional view of portions of the exemplary die bonding method.

As further shown in Figure 1 A, the donor die 102 and the target die 104 may be brought together along the z-axis, while the position of the donor die 102 or the target die 104 may be adjusted in the x-y plane (e.g., perpendicular to the z-axis of approach). As shown in Figure IB, the donor die 102 and the target die 104 may be annealed after contact. Annealing may be or include heat annealing, electrical annealing, electrostatic processes, van der Waals processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 in the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure ID depicts a plan view of an example die bonding method according to this disclosure. As shown in Figure ID, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or substractively fabricated, such as by etching or deposition in the z-direction. Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non- zero linewidth portion of the wafer volume when separating die. Alternatively, the electrically active areas 106 of the donor die 102 or the electrically active areas 108 of the target die 104 (not shown in Figure ID) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the X axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

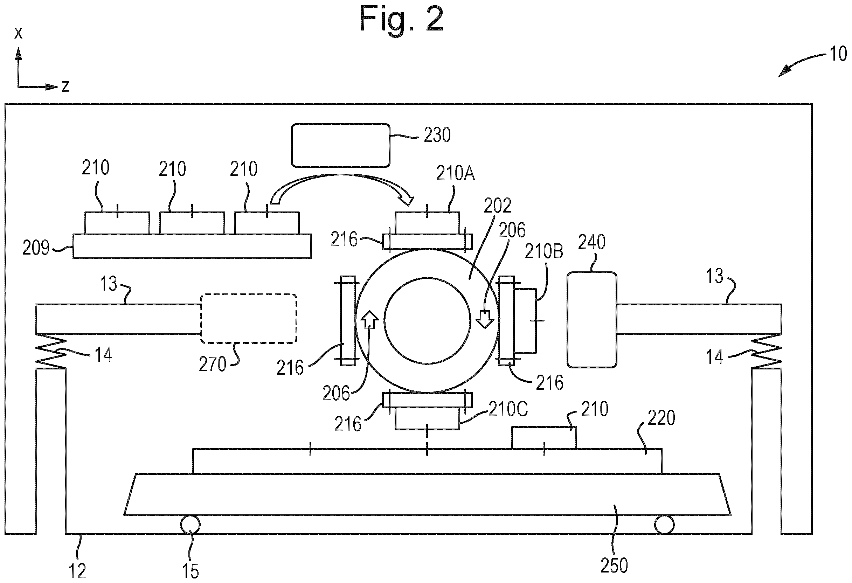

Figure 2 is a schematic diagram illustrating a method of placement of donor dies by a moveable stage with recesses. Figure 2 depicts a bonding tool 10. Figure 2 is described with reference to "donor die" and "target die", which are relative descriptors and donor die may instead be target die and vice versa. Figure 2 is a cross-sectional view of placement of donor die 210A-210D using support stage 202. The support stage 202 is substantially circular in the x-z plane, with a longitudinal axis 204 along the y-direction (e.g., the support stage 202 is substantially cylindrical in three dimensions). The support stage 202 may instead have a different cross-sectional shape, such as square, hexagonal, etc. The support stage 202 may have a symmetrical (e.g., as shown) cross-section with one or more axis of symmetry, or asymmetrical cross-sectional area (for example, an irregular polygon).

The support stage 202 has die acceptors 216. The placement of the die acceptors 216 may be symmetrical or asymmetrical around the cross-sectional area of the support stage 202. The support stage 202 may have a substantially symmetrical cross section but have asymmetric placement of recesses. For example, the support stage 202 may have a cross-section that is a regular hexagon but have recesses placed asymmetrically along longitudinal faces. The die acceptors 216 are capable of accepting donor dies, such as the donor dies 210A- 210D.

The support stage 202 may be controllably moved in a direction 206 about the longitudinal axis 204. The direction 206 is provided as an example. The support stage 202 may instead be rotated in an opposite direction or any appropriate direction, translated along the x, y, or z direction or any combination thereof. The support stage 202 may be operated in both rotational and a translational modes, including sequentially or at the same time. For example, the support stage 202 may move in the negative x-direction towards a support structure 250 while also rotating about the longitudinal axis 204. The support stage 202 may move continuously or intermittently. For example, the support stage 202 may rotate in the direction 206 and stop at four (or fewer or more) positions corresponding to operations in the placement of die. Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the support stage 202 is substantially zero), but the positions may instead correspond to continuous (or quasi-continuous movement) or operations may occur while the support stage 202 is moving in one or more directions (e.g., rotationally, translationally, etc.).

A first position, such as corresponding to the position depicted for the donor die 210A, may correspond to placement of die in die acceptors 216 of the support stage 202. The donor die 210A may be placed on the die acceptor 216 by a pick and place element 230. The pick and place element 230 may place the donor die 210A on the support stage 202 on the die acceptor 216 based on alignment information, based on positional information of the support stage 202, etc. The pick and place element 230 may place the donor die 210A on the support structure at a given position relative to the die acceptor 216. For example, the pick and place element 230 may center the donor die 210A relative to the die acceptor 216. The pick and place element 230 may have intrinsic error or inaccuracy.

The second position, such as corresponding to the position depicted for the donor die 210B, may correspond to measurement of the position of the die in recesses (e.g., of the donor die 210B relative to the die acceptor 216) of the support stage 202. The position (e.g., location) of the donor die 210B may be measured by a location measurement element 240. The location measurement element 240 may measure an actual position of the donor die 210B, in relative (such as relative to the die acceptor 216) or absolute terms (such as in distances from an origin point on the support stage 202, on the location measurement element 240, etc.). The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the y-z plane (relative to the refence axes) and an out of plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the support stage 202.

Once the position of the donor die 210B is measured, the support stage 202 may move (e.g., in the direction 206), so that the donor die 210B occupies the position of the donor die 210C which may be a third position of the support stage 202. The third position of the support structure will now be described with reference to the donor die 210C.

The third position, such as corresponding to the position depicted for the donor die 210C, may correspond to placement of the die on a corresponding target, for example, an acceptor substrate 220. The acceptor substrate 220 may comprise one or more target dies which may be sequentially contacted by a donor die during various movements of the support stage 202.

The acceptor substrate 220 is supported by the support structure 250. The donor die 210C may be placed on the acceptor substrate 220 by motion of the support stage 202 towards the acceptor substrate 220. Alternatively or additionally, the support structure 250 may also be a moveable structure operable to bring the donor die 210C and the acceptor substrate 220 into contact.

Once the donor die 210C is placed on the acceptor substrate 220, the support stage 202 and the support structure 250 may operate (individually or in concert) to place additional donor dies on the acceptor substrate 220. For example, the support structure 250 may move in the negative z-direction so that another part of the acceptor substrate 220 is proximate to the support stage 202 and a donor die (for example, the donor die 210B after rotation of the support stage 202) may be placed on the acceptor substrate 220. The relative motion of the support stage 202 and the support structure 250 may occur in any appropriate direction. A direction of gravity is not depicted, but the placement of the donor die 210C on the acceptor substrate 220 may experience gravitation effects. For example, the placement of the donor die 210C on the acceptor substrate 220 may be encouraged by gravity (e.g., occur in the direction of gravity) or be retarded by gravity (e.g., occur opposite the direction of gravity). Gravitational effects may be balanced by die clamps, suction, vacuum, and other forces.

The stage 202 shown in Figure 2 is for die placement. The stage 202 is for placing dies 210, for example onto an acceptor substrate 220. The stage 202 comprises an actuator. The actuator is configured to cause the stage 202 to accept the dies 210 from pick & place element 230 and subsequently transport the dies 210 to alignment sensor 240 and finally place the dies 210 on the acceptor substrate 220.

In an embodiment the stage 202 is coupled to a frame such as the base frame 12 or the metrology frame 13. In an embodiment the stage 202 comprises a movable member 20. The movable member 20 is configured to move relative to the frame such that an actuation force applied to the movable member 20 causes a reaction force. For example, when the movable member 20 accelerates or decelerates, it is possible that the frame on which the stage 202 is mounted may be excited by the reaction forces.

During use of the stage 202, the movable member 20 may undergo high acceleration and deceleration rotationally about the Y axis and translationally along the X axis. There may be accelerations and decelerations about other degrees of freedom.

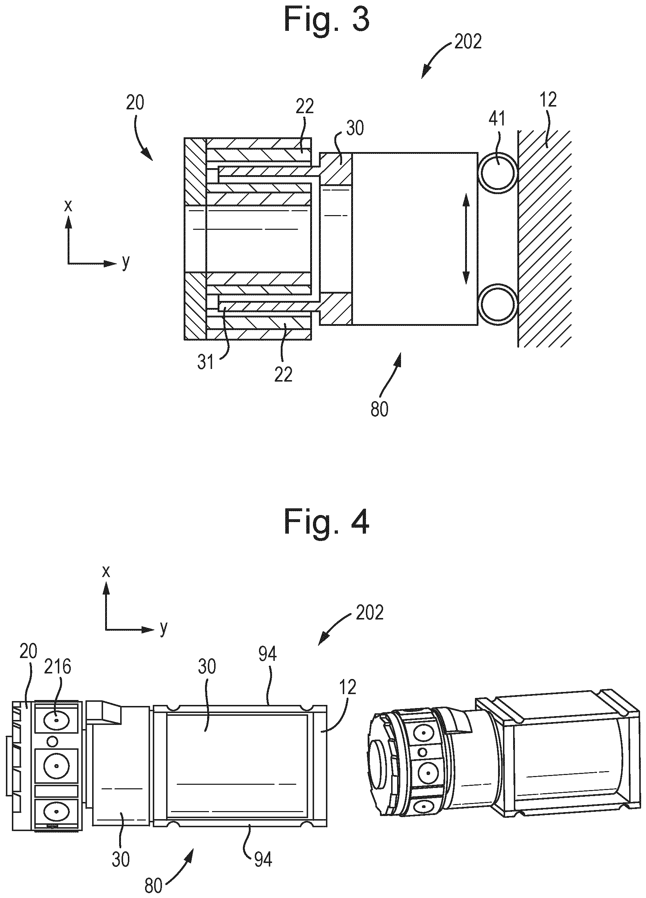

Figure 3 is a schematic diagram showing the stage 202 coupled to the base frame 12. As shown in Figure 3, in an embodiment the bonding tool 10 comprises a balance mechanism 80. The balance mechanism 80 is configured to at least partly counteract the reaction force caused by the actuation force applied to the movable member 20. By at least partly counteracting the reaction force, the excitation of the base frame 12 due to the reaction forces of aggressive acceleration and deceleration set points of the movable member 20 may be reduced. An embodiment of the invention is expected to reduce undesirable excitation of the frame. By reducing undesirable excitation of the frame, it may be possible to place a die 210 more accurately. An embodiment of the invention is expected to improve accuracy of die placement.

As shown in Figure 3, in an embodiment the stage 202 comprises a support member 30. The support member 30 is coupled to the frame. In an embodiment the movable member 20 is configured to move relative to the support member 30. For example, the stage 202 may comprise an actuator configured, on actuation, to move the movable member 20 relative to the support member 30.

Different types of actuator are possible. As one example, the actuator of the stage 202 may be a Lorentz force actuator. For example, as shown in Figure 3 the stage 202 may comprise coils 31 and magnets 22. As shown in Figure 3, in an embodiment the coils 31 may be comprised in the support member 30. The magnets 22 may be comprised in the movable member 20. By providing the coils 31 in the support member 30, it may be easier to provide electrical transmission lines to the coils 31. Similarly, it may be easier to feed through fluid conduits for applying thermal conditioning fluid for cooling the coils 31.

In the arrangement shown in Figure 3, the stage 202 comprises a movable member 20 that is shaped as a wheel or a turret, for example. The movable member 20 may be generally arranged relative to the Y axis as its primary axis. During use of the bonding tool 10, the movable member 20 may rotate about the Y axis and move translationally along the X axis. In an embodiment the movable member 20 may be moved relative to the support member 30 in six degrees of freedom.

During use of the stage 202, an actuation force is applied to the movable member 20 to cause the movable member 20 to move relative to the support member 30. For example, in order to move the movable member 20 in the X-direction, an actuation force may be applied to the movable member 20 in the X-direction. This may cause a reaction force on the support member 30. The reaction force may be in the opposite direction from the direction of the actuation force. For example, when the movable member 20 is moved in the +X-direction, then the reaction force may be applied to the support member 30 in the -X-direction. The reaction force may be applied to the support member 30.

In an embodiment the balance mechanism 80 is configured to reduce the extent by which the reaction force is applied to the base frame 12. In an embodiment the balance mechanism 80 is configured to substantially prevent the reaction force from being applied to the base frame 12.

As shown in Figure 3, in an embodiment the support member 30 is coupled to the base frame 12 by a guide 41. The guide 41 may be configured to allow movement of the support member 30 relative to the base frame 12 in a degree of freedom. For example, in the arrangement shown in Figure 3, the guide 41 may be configured to allow the support member 30 to move relative to the base frame 12 along the X-direction. When actuation force is applied to the movable member 20 relative to the small body 30 in the degree of freedom, the reaction force is caused to accelerate the support member 30 relative to the base frame 12. As a result, the support member 30 and the guide 41 form the balance mechanism 80.

In an embodiment the actuator of the stage 202 generates a force to move the movable member 20 up and down and to apply a pressing force to initiate the bond between the die 210 that is placed and the acceptor substrate 220. The support member 30 may be mounted on a linear guide 41. The support member 30 acts as a balance mass. The reaction force accelerates the support member 30 in the opposite direction of the movement of the movable member 20. As a result, excitation of the base frame 12 may be reduced.

As shown in Figure 3, in an embodiment the degree of freedom allowed by the guide 41 is a linear translation. The guide 41 may be referred to as a linear guide. However, it is not essential for the guide 41 to be a linear guide. In an alternative embodiment, the guide 41 may be a rotational guide, for example.

In an embodiment the guide 41 comprises at least one of a gas bearing, a magnetic bearing and a roller bearing such as a ball bearing. In an embodiment the guide 41 comprises a plurality of types of bearing. The guide 41 may be configured to restrict movement of the support member 30 relative to the base frame 12 in other degrees of freedom. For example, in the arrangement shown in Figure 3 the guide 41 may be configured to substantially prevent movement of the support member 30 relative to the base frame 12 in the Y axis, the Z axis and in any rotational sense.

It is not essential for the guide 41 to comprise any of a gas bearing, a magnetic bearing or a ball bearing. For example, in an embodiment the guide 41 comprises parallel leaf springs 94. Figure 4 schematically depicts a stage 202 in which the support member 30 is connected to the base frame 12 by parallel leaf springs 94. As shown in Figure 4, in an embodiment the leaf springs 94 are substantially planar, extending substantially in the Y-Z plane. The leaf springs 94 may be substantially parallel to each other. The leaf springs 94 may be located on opposite sides of the support member 30 in the X-direction.

As shown in Figure 4, in an embodiment the die acceptors 216 are located on the movable member 20. During use of the stage 202, the die acceptors 216 may be moved relative to the support member 30 so as to place the dies 210 on the acceptor substrate 220.

In the arrangement shown in Figure 4, the balance mechanism 80 may comprise the support member 30 and the leaf springs 94. The leaf springs 94 may be configured to allow the support member 30 to move relative to the base frame 12 along the X-direction. The leaf springs 94 may substantially prevent movement of the support member 30 relative to the base frame 12 in other degrees of freedom. The leaf springs 94 may be configured to be compliant for motion in the X-direction.

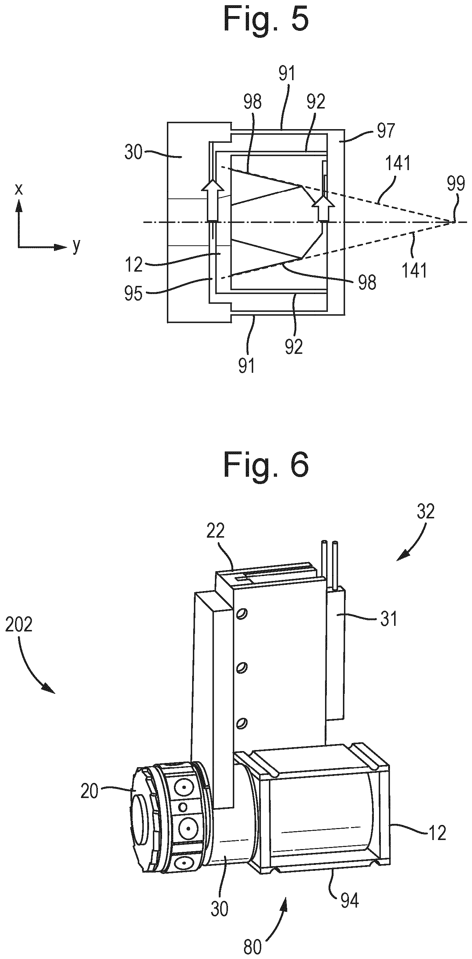

Figure 5 schematically depicts an alternative coupling between the support member 30 and the base frame 12. As shown in Figure 5, in an embodiment the guide (i.e. the coupling between the support member 30 and the base frame 12) comprises an intermediate body 97. The guide may further comprise first parallel leaf springs 91. The first parallel leaf springs 91 may connect the support member 30 to the intermediate body 97. The guide may comprise second parallel leaf springs 92. The second parallel leaf springs may connect the intermediate body 97 to the base frame 12. As shown in Figure 5, in an embodiment the second parallel leaf springs 92 are located inwardly of the first parallel leaf springs 91 in the X-direction.

By providing first and second parallel leaf springs 91, 92, the parallel leaf spring guide is doubled compared to the arrangement shown in Figure 4. By doubling the parallel leaf spring guide, parasitic motion of the single parallel leaf spring shown in Figure 4 may be reduced. For example, it is possible that there may be some parasitic motion of the support member 30 relative to the base frame 12. A parasitic motion is a motion in a degree of freedom other than the degree of freedom allowed by the guide 41 formed by the parallel leaf springs 94.

As shown in Figure 5, in an embodiment the guide 41 comprises lever flexures 98. The lever flexures 98 are connected to the base frame 12 and are angled relative to each other so as to form a virtual hinge 99. The virtual hinge 99 is a hinge between the intermediate body 97 and the support member 30. As shown in Figure 5, the virtual hinge 99 may be located at the imaginary point at which the imaginary lines 141 that are continuations of the lever flexures 98 in the X-Y plane coincide.

By providing the virtual hinge 99, the motion of the intermediate body 97 and the support member 30 can be made to be dependent on each other. By providing the virtual hinge 99, the Eigenfrequency of the intermediate body may be increased. This may help to improve the behaviour of the intermediate body 97 particularly at low frequencies of motion.

Figure 6 schematically depicts a stage 202. The stage 202 may be comprised in the bonding tool 10, for example as shown in Figure 2. Features of the stage 202 that are the same as described above are not repeated for conciseness.

As shown in Figure 6, in an embodiment the bonding tool 10 comprises an anti-drift mechanism 32. The anti-drift mechanism 32 is configured to apply an anti-drift force to the support member 30 relative to the base frame 12. Figure 6 shows an example in which the anti-drift mechanism 32 comprises a Lorentz force actuator formed from coils 31 and magnets 22. In the arrangement shown in Figure 6, the coils 31 are fixed relative to the base frame 12. The magnets 22 are fixed relative to the support member 30.

By providing the anti-drift mechanism, desirable movement (i.e. drift) of the support member 30 due to reaction forces may be reduced. For example, in an embodiment the anti-drift mechanism 32 is configured to apply the anti-drift force when the actuation force on the movable member 20 is pressing the movable member 20 against another body. When the die 210 to be placed is pressed onto the acceptor substrate 220, the reaction force on the support member 30 may continue to accelerate the support member 30 in the opposite direction, while the movable member 20 may remain substantially stationary. It will be undesirable for the support member 30 to move. The anti-drift mechanism 32 reduces such undesirable movement of the support member 30.

In an embodiment the anti-drift mechanism 32 is configured to apply the anti-drift force so as to move the support member 30 to a target position relative to the base frame 12. For example, the bonding tool 10 may comprise a location measurement element configured to measure the location of the support member 30 relative to the base frame 12. When it is determined that the support member 30 is located away from a target position, then the anti-drift mechanism 32 may be configured to apply the anti-drift force so as to move the support member 30 to the target position relative to the base frame 12.

As shown in Figure 6, in an embodiment the anti-drift mechanism 32 comprises a Lorentz force actuator. However, it is not essential for the anti-drift mechanism 30 to comprise a Lorentz force actuator. In an alternative arrangement, the anti-drift mechanism may comprise a different type of actuator such as a piezoelectric actuator.

In an embodiment the actuator is configured to generate a DC force to counteract pressing forces when the movable member 20 is pressing a die 210 on the acceptor substrate 220. The anti-drift mechanism 32 may be configured to return the support member 30 back to its neutral position while rotating towards the next die 210.

As shown in Figure 6, in an embodiment the Lorentz force actuator comprises coils 31 fixed relative to the base frame 12 and magnets 22 fixed relative to the support member 30. By providing that the magnet yoke is mounted on the support member 30, the mass of the magnet yoke contributes to the balance mass. The support member 30 functions as the balance mass such that fixing the magnet yoke relative to the support member 30 effectively increases the balance mass. By providing that the coils 31 are fixed relative to the base frame 12, the cables for the coils 31 may be routed more easily between the base frame 12 and the moving components of the stage 202.

In an embodiment the anti-drift mechanism 32 is configured to apply an actuator force on the centre of mass of the stage 202 so as to reduce or avoid torques.

It is not essential for the anti-drift mechanism 32 to comprise an actuator. In an alternative arrangement, the anti-drift mechanism 32 comprises an anti-drift spring. The anti-drift spring may be configured to apply the anti-drift force so as to reduce drift of the support member 30. When the support member 30 is configured to rotate under a reaction force, then the anti-drift spring may be a torsional spring.

It is not essential for the bonding tool 10 to be provided with an anti-drift mechanism 32. In an alternative arrangement, the anti-drift mechanism 32 may be omitted. In an embodiment, the stroke of any undesirable drift of the support member 30 may be reduced by increasing the stiffness of the leaf springs 94. By increasing the stiffness, undesirable drift may be reduced.

Alternatively, it may be desirable to provide leaf springs 94 with a relatively low stiffness so as to reduce any undesirable cross torque of forces towards the base frame 12.

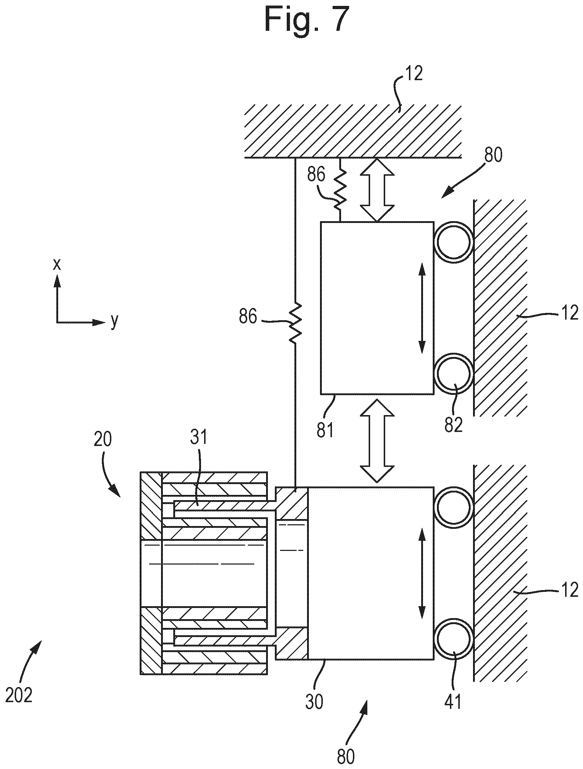

Figure 7 schematically depicts a stage 202 of a bonding tool 10. As shown in Figure 7, in an embodiment the bonding tool 10 comprises a gravity compensator 86. The gravity compensator 86 couples the base frame 12 to the support member 30. The gravity compensator 86 is configured to compensate for gravity on the support member 30.

For example, the stiffness of the guide 41 coupling the support member 30 to the base frame 12 may be relatively low. The gravity compensator 86 may help to reduce the possibility of the support member 30 undesirably falling down relative to the base frame 12.

As shown in Figure 7, in an embodiment the gravity compensator 86 comprises a spring. The gravity compensator 86 may be configured to hold the support member 30 suspended from the base frame 12. In an embodiment the spring that forms the gravity compensator 86 may have relatively low stiffness. The gravity compensator 86 may be mounted between the support member 30 and the base frame 12.

However, it is not essential for the gravity compensator 86 to comprise a spring. In an alternative embodiment, the gravity compensator comprises a magnetic member. For example, a magnet may be provided in the base frame 12 above the support member 30. Magnetic material may be provided as part of the support body 30 such that the attraction force compensates for gravity on the support member 30. As a further alternative, the gravity compensator 86 may be pneumatic. For example, an under pressure may be applied above the support member 30 for compensating for the effect of gravity on the support member 30.

It is not essential for the gravity compensator to be above the component on which gravity acts. In an alternative arrangement, the gravity compensator may push up the component from below.

Figure 7 schematically depicts the balance mechanism 80 formed by the support member 30 and the guide 41. This balance mechanism 80 is configured to balance reaction forces applied by the movable member 20 on the support member 30 of the stage 202.

**In** an embodiment, an actuator may be provided for actuating the support member 30 relative to the base frame 12 along the guide 41. This actuation may result in a reaction force. As shown in Figure 7, a balance mechanism 80 (shown towards the top of Figure 7) may be provided for balancing the reaction forces due to the actuation forces on the support member 30 along the guide 41. This other balance mechanism 80 may be provided in addition to, or instead of, the other balance mechanism 80.

As shown in Figure 7, in an embodiment the balance mechanism 80 comprises a balance actuator configured to apply a balancing force on the base frame 12, the balancing force opposing the reaction force that is applied to the base frame 12. When the support member 30 is actuated (together with the movable member 20) in the X-direction relative to the base frame 12 along the guide 41, a reaction force is exerted. An opposing reaction force may be applied to the base frame 12 by the balance mechanism 80 that comprises the balance mass 81.

In an embodiment the balance actuator 80 and the stage 202 are each coupled to the frame substantially independently of each other. For example, Figure 7 shows the stage 202 coupled to the base frame 12 by the linear guide 41. Figure 7 further shows the balance mechanism 80 that comprises the balance mass 81 coupled relative to the base frame 12 by a balance guide 82. The balance mechanism 80 may compensate for reaction forces in a degree of freedom.

When the stage 202 is actuated relative to the base frame 12 along the linear guide 41, the balance mass 81 may be controlled to move relative to the base frame 12 in the opposite direction. Depending on the mass of the balance mass 81 relative to the mass of the stage 202, the stroke of the balance mass 81 may be different from the stroke of the stage 202.

As shown in Figure 7, in an embodiment the reaction force and the balancing force are linear forces. In an alternative arrangement, the reaction force and the balancing force may be torques.

As shown in Figure 7, in an embodiment a gravity compensator 86 is provided for compensating for gravity on the balance mass 81. The possible features of the gravity compensator 86 for the balance mass 81 may be substantially the same as the possible features described elsewhere for the gravity compensator 86 for the support member 30.

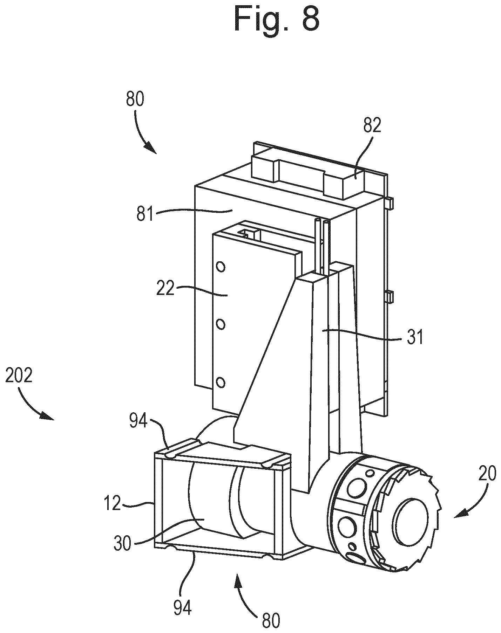

Figure 8 schematically depicts a stage 202 that may be comprised in a bonding tool 10 such as shown in Figure 2, for example. Features of the stage 202 described with reference to other Figures are not repeated, for conciseness.

In an embodiment the balance guide 82 comprises a bearing such as a gas bearing, a magnetic bearing or a parallel leaf spring.

Figure 8 schematically depicts a balance guide 82 configured as a linear guide. The balance guide 82 is configured to allow the stage 202 to move relative to the base frame 12 in the vertical direction. In an embodiment the balance guide 82 comprises an anti-drift mechanism as described elsewhere.

As shown in Figure 8, in an embodiment the stage 202 comprises an X-direction actuator comprising magnets 22 and coils 31 for actuating the support member 30 together with the movable member 20 in the X-direction relative to the bass frame 12. As shown in Figure 8, in an embodiment the magnets 22 are secured relative to the balance mass 81 so as to contribute to the balance mass 81 of the balance mechanism 80. The balance mechanism 80 that comprises the balance mass 81 is for balancing reaction forces due to the actuation forces applied between the coils 31 and the magnets 22 of the X-direction actuator. The coils 31 may be mounted on the support member 30 of the stage 202.

By providing that the coils 31 are secured to the support member 30, the total mass of the support member 30 may be reduced. This may help to provide for accurate control of the movement of the support member 30 in the X-direction by actuation from the X-direction actuator comprising the magnets 22 and the coils 31.

As shown in Figure 8, two balance mechanisms 80 may be provided. One balance mechanism 80 may be provided for compensating for reaction forces due to actuation of the movable member 20 relative to the support member 30. Another balance mechanism 80 may be provided for compensating for reaction forces due to X-direction actuation of the support member 30 together with the movable member 20.

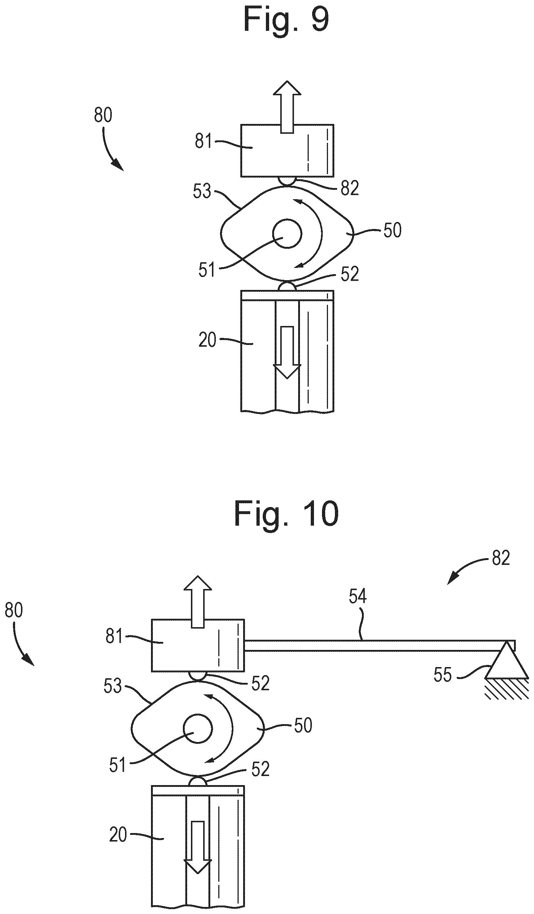

Figure 9 schematically depicts an alternative balance mechanism 80. As shown in Figure 9, in an embodiment the bonding tool 10 comprises a cam actuator 50. The cam actuator 50 is configured, on actuation, to rotate so as to apply the actuation force to the movable member 20. In the arrangement shown in Figure 9, the cam actuator 50 may rotate with a shaft 51. The shaft 51 may be rotated by a rotary actuator, for example, relative to the base frame 12.

As shown in Figure 9, in an embodiment the rotation of the cam actuator 50 may cause the movable member 20 be actuated in the vertical direction (i.e. radially away from the cam actuator 50 or towards the cam actuator 50).

As shown in Figure 9, in an embodiment a bearing is provided between the cam actuator 50 and the movable member 20. For example, the bearing may comprise a rotatable ball 52 so as to reduce some desirable friction between the cam actuator 50 and the movable member 20.

Figure 9 shows the movable member 20 in its upmost position. As the cam actuator 50 rotates, the movable member 20 is caused to move downwards in the orientation shown in Figure 9.

As shown in Figure 9, in an embodiment the bonding tool 10 comprises a balance mass 81 (which may be referred to as a balance body). The balance mass 81 is configured to move relative to the base frame 12. In an embodiment the cam actuator 50 is configured, on actuation, to rotate so as to apply a balance force to the balance mass 81. The direction of the balance force may be substantially opposite to the direction of the actuation force. The balance mass 81 and the cam actuator 50 may form the balance mechanism 80.

As the cam actuator 50 rotates, the balance mass 81 is moved in the opposite sense from the movement of the movable member 20. The movement of the balance mass 81 at least partially compensates for reaction forces due to actuation of the movable member 20.

As shown in Figure 9, the balance mass 81 may be provided with a bearing such as a rotatable ball 52 so as to couple to the cam actuator 50. During rotation of the cam actuator 50, the rotatable ball 52 may rotate so as to reduce or avoid any undesirable friction between the balance mass 81 and the cam actuator 50.

Figure 9 shows the balance mass 81 in its lower most position. As the cam actuator 50 rotates, the surface 53 of the cam actuator 50 engages with the balance mass 81 so as to move the balance mass 81 upwards in the orientation shown in Figure 9.

As shown in Figure 9, in an embodiment the cam actuator 50 has a surface 53 that engages with the balance mass 81. Part of the surface 53 may be linear. Another part of the surface 53 may be curved, for example cylindrical.

As shown in Figure 9, in an embodiment the balance mechanism 80 is arranged such that the rotatable balls 52 are located on a cylindrical part of the cam actuator 50 when the movable member 20 is at its upmost position. This reduces the torque required to be applied by the motor that rotates the cam actuator 50 in order to keep the movable member at that position in the X-direction. This may help to reduce power when the movable member 20 is most likely to be located in that position during use of the bonding tool 10.

In an embodiment the balance mass 81 is provided with a guide. For example, the guide may be configured to guide movement of the balance mass 81 relative to the base frame 12. The guide may be a linear guide, for example.

However, it is not essential for the guide to be a linear guide. Figure 10 schematically depicts a balance mechanism 80 in which the balance guide 82 for the balance mass 81 is a rotation guide. In an embodiment, the motions of the balance mass 81 are relatively small such that the rotational guide 82 shown in Figure 10 may approximate a linear guide over the range of movement of the balance mass 81. As shown in Figure 10, in an embodiment the balance guide 82 comprises a lever 54 and a rotation point 55. The lever 54 is configured to rotate about the rotation point 55. The lever 54 is connected to the balance mass 81. The balance mass 81 may rotate about the rotation point 55.

In an embodiment, a mass of the balance mass 81 is substantially equal to a mass of the movable member 20. By moving the balance mass 81 oppositely to the movable member 20, the reaction force due to the movable member 20 may be substantially cancelled out.

As shown in Figure 9 and Figure 10, in an embodiment the cam actuator 50 is substantially symmetric. As the cam actuator 50 rotates, the balance mass 81 may move substantially the same distance as the distance by which the movable member 20 moves. The balance mass 81 moves in the opposite direction from the movable member 20.

However, it is not essential for the cam actuator 50 to be symmetric. For example, when the balance mass 81 is heavier or lighter than the movable member 20, then the cam actuator 50 may be asymmetric. When the asymmetric cam actuator rotates, the balance mass 81 may move a distance that is different from the distance by which the movable member 20 moves. For example, if the balance mass 81 is ten times heavier than the movable member 20, then the cam actuator 50 may have a profile such that the movement of the balance mass 81 during rotation of the cam actuator 50 is ten times shorter than movement of the movable member 20.

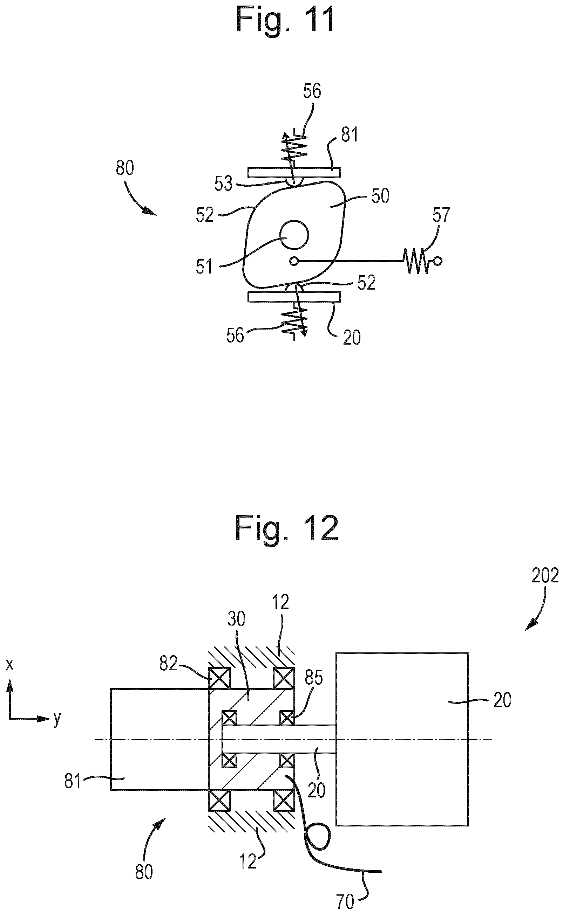

Figure 11 schematically depicts optional features of the balance mechanism 80 shown in Figure 9 and Figure 10. As shown in Figure 11, in an embodiment the bonding tool 10 comprises at least one biasing member 56. The biasing member 56 is configured to bias at least one of the movable member 20 and the balance mass 81 into contact with the cam actuator 50. As shown in Figure 11, in an embodiment each of the movable member 20 and the balance mass 81 is provided with a biasing member. The biasing member 56 may be, for example, a spring. The spring may be used to preload the movable member 20 and the balance mass 81 to the cam actuator 50. The biasing members 56 may help to increase the accuracy of movement of the movable member 20 and the balance mass 81.

In an embodiment the biasing member 56 can be tuned such that the needed torque of the actuator that rotates the cam actuator 50 is reduced, for example, minimised when the cam actuator 50 is substantially stationary relative to the base frame 12.

In an embodiment, the bonding tool 10 comprises a compensator spring 57. As shown in Figure 11, the compensator spring 57 may be between the cam actuator 50 and the base frame 12. The compensator spring 57 may be configured to compensate for a biasing torque applied to the cam actuator 50 by the at least one biasing member 56.

During rotation of the cam actuator 50, only a relatively small portion of the surface 56 may come into contact with the balance mass 81. The stroke of the cam actuator 50 may be less than 45°, optionally less than 30°, optionally less than 20° and optionally less than 10° around the shaft 51.

In the arrangements shown in Figures 3-11, the reaction forces and the balancing forces are substantially linear. However, in alternative embodiments, the forces may be rotational. Figure 12 schematically depicts a balance mechanism 80 for rotational forces. As shown in Figure 12, in an embodiment the movable member 20 is configured to rotate relative to the base frame 12. The movable member 20 may be rotatable relative to the support member 30. The movable member 20 may be coupled to the support member 30 by a bearing 85.

As shown in Figure 12, in an embodiment at least one cable 70 is connected to the support member 30, for example for supplying power to the support member 30.

As shown in Figure 12, in an embodiment the support member 30 is coupled to the base frame 12 such that the support member 30 is rotatable relative to the base frame 12. For example, the support member 30 may be coupled to the base frame 12 by a support bearing 82. The support bearing 82 may be, for example, a magnetic bearing, a gas bearing or a ball bearing.

As shown in Figure 12, optionally an additional balance mass is secured to the support member 30 so as to increase the overall mass for providing the balance force. When the movable member 20 is actuated relative to the support member 30, a reaction force, which is rotational, acts on the support member 30. The reaction force can accelerate the support member 30 together with the optional additional balance mass 81. The support member 30 together with the balance mass 81 supported by the support bearing 82 function as the balance mechanism 80. The balance mechanism 80 is configured to reduce undesirable forces on the base frame 12.

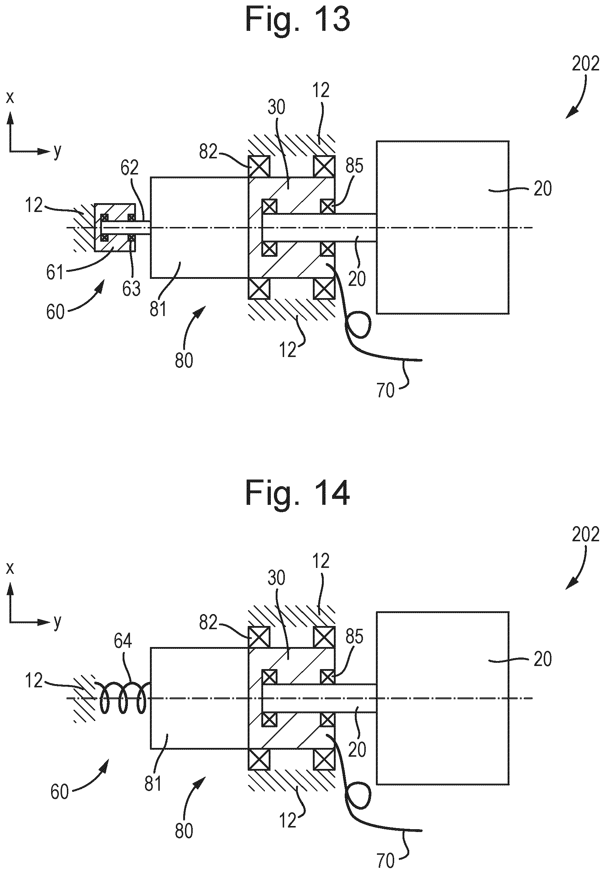

Figure 13 schematically depicts a modified version of the apparatus shown in Figure 12. As shown in Figure 13, in an embodiment the stage 202 is provided with an anti-drift mechanism 60. The anti-drift mechanism 60 may comprise an anti-drift actuator 61 configured to rotate a shaft 62 relative to the base frame 12. The shaft 62 may be supported by anti-drift bearings 63 relative to the anti-drift actuator 61. The anti-drift actuator 61 may be secured to the base frame 12. The shaft 62 of the anti-drift mechanism 60 may be secured to the balance mass 81 or the support member 30.

The anti-drift mechanism 60 is configured to reduce the possibility of the support member 30 and/or the balance mass 81 drifting too much. Any such undesirable drift could lead to undesirable damage of the cables 70 that supply, for example, power to the support member 30.

In the arrangement shown in Figure 13, the anti-drift mechanism 60 comprises an anti-drift actuator. However, it is not essential for an anti-drift actuator to be provided. Figure 14 schematically depicts an alternative embodiment in which the anti-drift mechanism 60 comprises a torsion spring 64. The torsion spring 64 is configured to passively reduce drift of the support member 30 and the balance mass 81.

In an embodiment the anti-drift mechanism 60 is configured to reduce the possibility of the velocity of the balance mass 81 being non-zero at the time that the velocity of the movable member 20 is zero. This can help to reduce the possibility of undesirable high velocities of the balance mass 81.

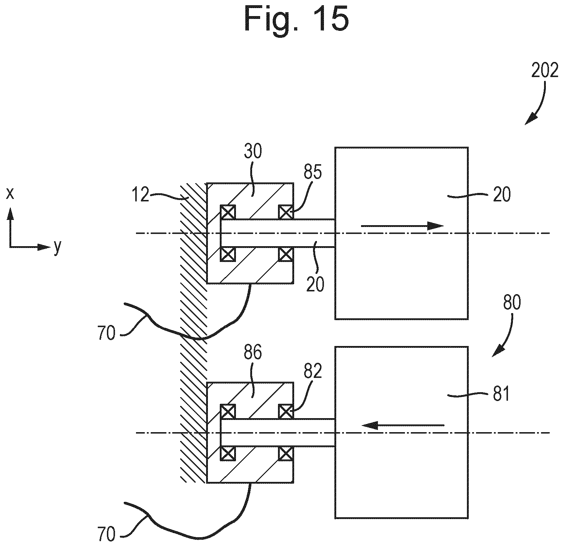

Figure 15 schematically depicts an alternative balance mechanism 80. As shown in Figure 15, in an embodiment the balance mechanism 80 is a substantially stand alone torque generator. The balance mechanism 80 is coupled to the base frame 12 substantially independently of the coupling between the base frame 12 and the stage 202 that comprises the movable member 20 and the support member 30.

In the arrangement shown in Figure 15, the balance mechanism 80 is configured to apply to the base frame 12 an opposite torque from the torque applied by the acceleration of the movable member 20 (and its reaction forces). However, the torque applied by the balance mechanism 80 is applied to a different part of the base frame 12 from the position of the torque applied by the stage 202. In an embodiment, the balance mechanism 80 is provided proximal, for example, adjacent to the stage 202 so as to reduce the distance between the torque applied by the stage 202 and the balance torque applied by the balance mechanism 80. This can help to reduce the possibility of the base frame 12 being undesirable deformed.

It may not be necessary to provide an anti-drift mechanism because the balance mechanism 80 is controlled substantially individually relative to the stage 202. As a result, drift may be avoided.

As shown in the Figures, in an embodiment one or more cables 70 are provided between the fixed world (e.g. the base frame 12) and a movable (e.g. rotating) world such as the movable member 20 or the support member 30. It is possible for particles to be undesirably generated, for example as the cables 70 flex.

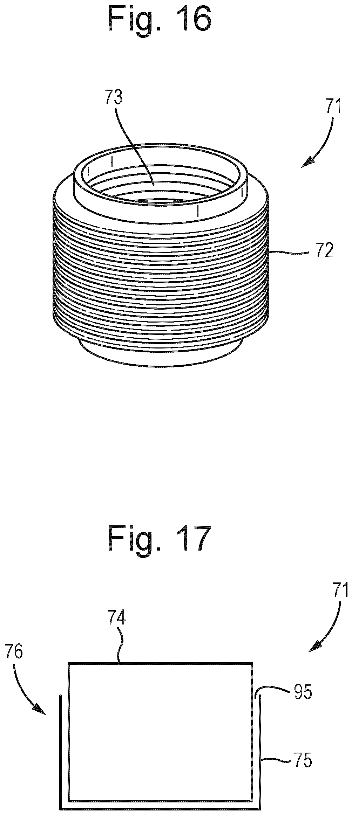

Figure 16 schematically depicts a housing 71 for at least one cable 70 connected between the fixed world and the movable world. As shown in Figure 16, in an embodiment the housing 71 comprises a bellow arranged to encapsulate a flexible component (e.g. cable 70 connected between the base frame 12 and the stage 202). The bellow is configured to deflect as the flexible component flexes. For example, the housing 71 may comprise corrugations 72 such that the axial length of the housing 71 may vary during use of the bonding tool 10. The flexible components such as cables 70 may extend through the openings 73 at the ends of the housing 71.

During use of the housing 71 shown in Figure 16, it is possible that an overpressure will be generated when the bellow is compressed. Similarly, an under pressure may be generated when the bellow is expanded. In an embodiment, a pressure equalising conduit is provided to controllably equalise pressure between the bellow and the external environment. The pressure equalising conduit may be a hose, for example. The hose may be routed to somewhere outside of the machine environment where particles can do no harm.

Figure 17 schematically depicts an alternative housing 71 for the flexible components. The housing 71 is configured to house the flexible component connected between the frame 12 and the stage 202. As shown in Figure 17, in an embodiment the housing 71 is provided with a labyrinth seal 76. The labyrinth seal 76 may be provided by a small gap 95 between two portions 74, 75 of the housing 71. For example, the portions 74, 75 may be concentric boxes with slightly different diameters such that the portions 74, 75 can move inside each other. The gap 95 between the boxes acts as a labyrinth seal. If an under pressure is applied to the inside, particles will not leave the enclosure.

In an embodiment the flexible component comprises at least one of an electrical transmission line, a conduit for fluid transfer and a spring.

**In** an embodiment the balance actuator is configured to apply the balancing force on the frame 12 so as to compensate for the reaction force associated with a plurality of stages of the bonding tool 10. For example, there may be a plurality of stages that result in reaction forces on the base frame 12 in the same degree of freedom. A single stand alone balance mechanism may be configured to compensate for the reaction forces on the stage 12 due to both of the stages.

**In** an embodiment, a plurality of balance mechanisms 80 are provided for balancing forces in a plurality of different degrees of freedom. For example, one balance mechanism 80 may be provided for balancing reaction forces that are translational forces in the X-direction, optionally associated with a plurality of stages. Another balance mechanism 80 may be configured to balance reaction forces that are rotational (i.e. torques) about the Y axis, optionally associated with a plurality of stages of the bonding tool 10.

Further embodiments of the invention are disclosed in the list of numbered clauses below:
1. A bonding tool comprising: a frame; a stage coupled to the frame, wherein the stage comprises a movable member configured to move relative to the frame such that an actuation force applied to the movable member causes a reaction force; and a balance mechanism configured to at least partly counteract the reaction force caused by the actuation force applied to the movable member.
2. The bonding tool of clause 1, wherein the stage comprises a support member coupled to the frame, wherein the movable member is configured to move relative to the support member.
3. The bonding tool of clause 2, wherein the reaction force is applied to the support member, and the balance mechanism is configured to substantially prevent the reaction force from being applied to the frame.
4. The bonding tool of clause 2 or 3, wherein the support member is coupled to the frame by a guide configured to allow movement of the support member relative to the frame in a degree of freedom, such that the actuation force applied to the movable member relative to the support body in the degree of freedom causes the reaction force to accelerate the support member relative to the frame, such that the support member and the guide form the balance mechanism.
5. The bonding tool of clause 4, wherein the degree of freedom is a linear translation.
6. The bonding tool of clause 4 or 5, wherein the guide comprises at least one of a gas bearing, a magnetic bearing and a ball bearing.
7. The bonding tool of any of clauses 4-6, wherein the guide comprises parallel leaf springs connecting the support member to the frame.
8. The bonding tool of any of clauses 4-7, wherein the guide comprises an intermediate body, first parallel leaf springs connecting the support member to the intermediate body and second parallel leaf springs connecting the intermediate body to the frame.
9. The bonding tool of clause 8, wherein the guide comprises lever flexures connected to the frame and angled relative to each other so as to form a virtual hinge between the intermediate body and the support member.
10. The bonding tool of any of clauses 2-9, comprising: a gravity compensator coupling the frame to the support member and configured to compensate for gravity on the support member.
11. The bonding tool of clause 4, wherein the degree of freedom is a rotation.
12. The bonding tool of any of clauses 2-11, comprising: an anti-drift mechanism configured to apply an anti-drift force to the support member relative to the frame.
13. The bonding tool of clause 12, wherein the anti-drift mechanism is configured to apply the anti-drift force when the actuation force is pressing the movable member against another body.
14. The bonding tool of clause 12 or 13, wherein the anti-drift mechanism is configured to apply the anti-drift force so as to move the support member to a target position relative to the frame.
15. The bonding tool of any of clauses 12-14, wherein the anti-drift mechanism comprises a Lorentz force actuator.
16. The bonding tool of clause 15, wherein the Lorentz force actuator comprises coils fixed relative to the frame and magnets fixed relative to the support member.
17. The bonding tool of any of clauses 12-14, wherein the anti-drift mechanism comprises an anti-drift spring.
18. The bonding tool of clause 17, wherein the anti-drift spring is a torsion spring.
19. The bonding tool of any of clauses 2-18, wherein the stage comprises: a stage actuator configured, on actuation, to apply the actuation force to the movable member.
20. The bonding tool of clause 19, wherein the stage actuator is a Lorentz force actuator.
21. The bonding tool of clause 20, wherein the Lorentz force actuator comprises coils fixed relative to the movable member and magnets fixed relative to the support member.
22. The bonding tool of clause 1 or 2, comprising: a cam actuator configured, on actuation, to rotate so as to apply the actuation force to the movable member.
23. The bonding tool of clause 22, comprising: a balance mass configured to move relative to the frame; wherein the cam actuator is configured, on actuation, to rotate so as to apply a balance force to the balance mass, a direction of the balance force being substantially opposite to a direction of the actuation force, such that the balance mass and the cam actuator form the balance mechanism.
24. The bonding tool of clause 23, wherein a mass of the balance mass is substantially equal to a mass of the movable member.
25. The bonding tool of clause 23 or 24, wherein the cam actuator is substantially symmetric.
26. The bonding tool of any of clauses 23-25, comprising: a balance mass guide configured to guide movement of the balance mass relative to the frame.
27. The bonding tool of clause 26, wherein the balance mass guide is configured to restrict the balance mass to a linear movement relative to the frame.
28. The bonding tool of any of clauses 23-27, comprising: at least one biasing member configured to bias at least one of the movable member and the balance mass into contact with the cam actuator.
29. The bonding tool of clause 28, comprising: a compensator spring between the cam actuator and the frame, the compensator spring configured to compensate for a biasing torque applied to the cam actuator by the at least one biasing member.
30. The bonding tool of clause 1 or 2, wherein the balance mechanism comprises:
   a balance actuator configured to apply a balancing force on the frame, the balancing force opposing the reaction force that is applied to the frame.
31. The bonding tool of clause 30, wherein the balance actuator and the stage are each coupled to the frame substantially independently of each other.
32. The bonding tool of clause 30 or 31, wherein the reaction force and the balancing force are torques.
33. The bonding tool of any of clauses 30-32, wherein the balance actuator is configured to apply the balancing force on the frame so as to compensate for the reaction force associated with a plurality of stages of the bonding tool.
34. The bonding tool of any preceding clause, comprising:
   a bellow arranged to encapsulate a flexible component connected between the frame and the stage, wherein the bellow is configured to deflect as the flexible component flexes.
35. The bonding tool of clause 34, comprising: a pressure equalising conduit configured to controllably equalise pressure between the bellow and an external environment.
36. The bonding tool of any preceding clause, comprising: a housing arranged to house a flexible component connected between the frame and the stage, wherein the housing is provided with a labyrinth seal; and an underpressure source configured to apply an underpressure within the housing so as to extract gas into the housing through the labyrinth seal.
37. The bonding tool of any of clauses 34-36, wherein the flexible component comprises at least one of an electrical transmission line, a conduit for fluid transfer and a spring.
38. The bonding tool of any preceding clause, wherein the stage is for placing a die onto an acceptor substrate.
39. The bonding tool of any of clauses 1-37, wherein the stage is for supplying dies to be placed onto an acceptor substrate.
40. A method for counteracting a reaction force within a bonding tool, the method comprising:
   applying an actuation force to a movable member of a stage of the bonding tool so as to move the movable member relative to a frame of the bonding tool, wherein the stage is coupled to the frame; and at least partly counteracting the reaction force caused by the actuation force applied to the movable member with a balance mechanism.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the clauses. The descriptions above are intended to be illustrative, not limiting. Thus, it will be apparent to one skilled in the art that modifications may be made as described without departing from the scope of the clauses set out below.

## Claims

1. A bonding tool comprising:
a frame;
a stage coupled to the frame, wherein the stage comprises a movable member configured to move relative to the frame such that an actuation force applied to the movable member causes a reaction force; and
a balance mechanism configured to at least partly counteract the reaction force caused by the actuation force applied to the movable member.

2. The bonding tool of claim 1, wherein the stage comprises a support member coupled to the frame, wherein the movable member is configured to move relative to the support member.

3. The bonding tool of claim 2, wherein the reaction force is applied to the support member, and the balance mechanism is configured to substantially prevent the reaction force from being applied to the frame.

4. The bonding tool of claim 2, wherein the support member is coupled to the frame by a guide configured to allow movement of the support member relative to the frame in a degree of freedom, such that the actuation force applied to the movable member relative to the support body in the degree of freedom causes the reaction force to accelerate the support member relative to the frame, such that the support member and the guide form the balance mechanism.

5. The bonding tool of claim 4, wherein the degree of freedom is a linear translation.

6. The bonding tool of claim 4, wherein the guide comprises at least one of a gas bearing, a magnetic bearing and a ball bearing.

7. The bonding tool of claim 4, wherein the guide comprises parallel leaf springs connecting the support member to the frame.

8. The bonding tool of claim 2, comprising:
a gravity compensator coupling the frame to the support member and configured to compensate for gravity on the support member.

9. The bonding tool of claim 4, wherein the degree of freedom is a rotation.

10. The bonding tool of claim 2, comprising:
an anti-drift mechanism configured to apply an anti-drift force to the support member relative to the frame.

11. The bonding tool of claim 10, wherein the anti-drift mechanism comprises a Lorentz force actuator.

12. The bonding tool of claim 2, wherein the stage comprises a stage actuator configured, on actuation, to apply the actuation force to the movable member.

13. The bonding tool of claim 1, wherein the balance mechanism comprises:
a balance actuator configured to apply a balancing force on the frame, the balancing force opposing the reaction force that is applied to the frame.

14. The bonding tool of claim 13, wherein the balance actuator and the stage are each coupled to the frame substantially independently of each other.

15. The bonding tool of claim 1, wherein the stage is for placing a die onto an acceptor substrate.
